Europäisches Patentamt

(19) European Patent Office  (11) Publication number: **0 090 566**

Office européen des brevets  **B1**

(12) **EUROPEAN PATENT SPECIFICATION**

(45) Date of publication of patent specification: 25.01.89  (51) Int. Cl.⁴: **H 01 L 23/04, H 01 L 23/48**

(21) Application number: 83301536.5

(22) Date of filing: 18.03.83

(54) Semiconductor device package.

(30) Priority: 29.03.82 JP 50734/82

(43) Date of publication of application:
05.10.83 Bulletin 83/40

(45) Publication of the grant of the patent:
25.01.89 Bulletin 89/04

(84) Designated Contracting States:
DE FR GB

(56) References cited:
EP-A-0 039 507
GB-A-1 181 621
GB-A-2 068 640
JP-A-55 027 615
US-A-3 585 711
US-A-4 229 758

(73) Proprietor: FUJITSU LIMITED
1015, Kamikodanaka Nakahara-ku
Kawasaki-shi Kanagawa 211 (JP)

(72) Inventor: Kida, Susumu
3-16-1-409 Kaminoge
Setagaya-ku Tokyo 158 (JP)
Inventor: Usami, Hayato
1364 Omaru
Inagi-shi Tokyo 206 (JP)
Inventor: Aoki, Hideji
Fujinodai-danchi 1-47-102 3486 Honmachida
Machida-shi Tokyo 194 (JP)

(74) Representative: Rackham, Stephen Neil et al
GILL JENNINGS & EVERY 53-64 Chancery Lane
London WC2A 1HN (GB)

Courier Press, Leamington Spa, England.

## Description

The present invention relates to a semiconductor device comprising a sealed package containing an integrated circuit chip and more particularly to an improvement in the electrical connections in such a package.

Such a semiconductor device typically comprises a package including a cap and a substrate and glass layers on the cap and substrate, the package including a gold layer and terminal areas, a silicon integrated circuit chip attached to the gold layer and a conductive metal terminal chip also attached to the gold layer, and bonding wires electrically connecting the terminal areas to the integrated circuit chip and to the metal terminal chip. The conductive metal terminal chip typically comprises an Fe-Ni-Co alloy or an Fe-Ni alloy metal base with an upper coating layer of aluminium or an aluminium silicon alloy. Such a conductive metal terminal chip is disclosed in JP—A—55—27615. However, we have now found that such a construction has a disadvantage because the bond strength between the metal terminal chip and the gold layer on the package substrate is reduced upon heating of the complete package to melt the glass layers to hermetically seal it. Naturally, this reduces the reliability of the resulting device.

According to this invention we overcome this disadvantage by applying a lower coating of a gold-silicon type of alloy to the metal terminal chip.

Preferably the gold-silicon type of alloy is an alloy of gold and silicon or an alloy of gold, germanium and silicon.

It is preferable that the silicon content of the gold-silicon alloy be from 1.0 to 8.0% by weight, taking the melting point (370°C) of the gold-silicon eutectic alloy into consideration.

In a case where the lower coating layer is formed by an alloy of gold, germanium and silicon on a metal base of the terminal metal chip and the obtained terminal metal is attached to the gold layer of the package substrate and then is heated in the sealing step, the present inventors found that the bond strength of the terminal metal chip is not decreased although in the case of the prior art bond strength of a terminal chip with a gold-germanium alloy coating layer is decreased by heating during the sealing step. It is preferable that the silicon content and the germanium content of the gold-germanium-silicon alloy be from 0.3 to 3% by weight and from 12 to 0% by weight, respectively.

The present invention will now be described and contrasted with the prior art with reference to the accompanying drawings in which:—

Figure 1 is a section through a typical Cerdip semiconductor device;

Figure 2 is a plan of a typical Cerdip semiconductor device with its ceramic cap removed;

Figure 3 is an enlarged sectioned side elevation of a metal terminal chip; and,

Figure 4 is a diagram showing the bond strength of conventional terminal metal chips and those used in the present invention.

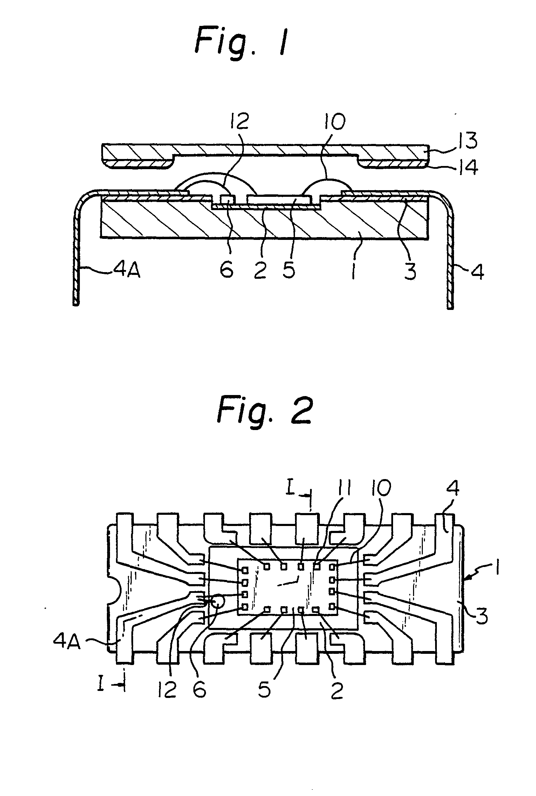

In a conventional process of producing a semiconductor device, a packaging step must be carried out. There are various kinds of well-known integrated-circuit packages in the art. For example, in the case of a dual in-line package (DIP), such as a so-called Cerdip, illustrated in Figures 1 and 2, a package substrate 1 of ceramic has a cavity in the centre portion. A gold paste is applied on the bottom surface of the cavity and is heated at a temperature of from 800°C to 950°C to form a gold layer 2. Then a glass paste having a low melting point is applied on the surface of the ceramic substrate 1, except for the cavity, and is pre-baked at a temperature of about 400°C to form a glass layer 3. A lead frame which comprises leads 4 and is made of an Fe-Ni-Co alloy (e.g. Kovar) or an Fe-Ni alloy (e.g. 42 Alloy) is set on the glass layer 3, and the ceramic substrate 1 is heated at a temperature of about 450°C to melt the glass layer 3 so that the leads 4 stick to the glass layer 3. In order to attach an integrated-circuit chip 5 to the package substrate 1 while the substrate 1 is being heated at a temperature of from 400°C to 450°C, the chip 5 is put on the gold layer 2 in such a manner that the gold layer 2 is scrubbed with the chip 5. As a result, the silicon of the integrated-circuit chip 5 is alloyed with the gold of the gold layer 2 to form a eutectic brazing alloy having a low melting point. Therefore, by forming a brazing alloy, the chip can be attached to the package substrate 1.

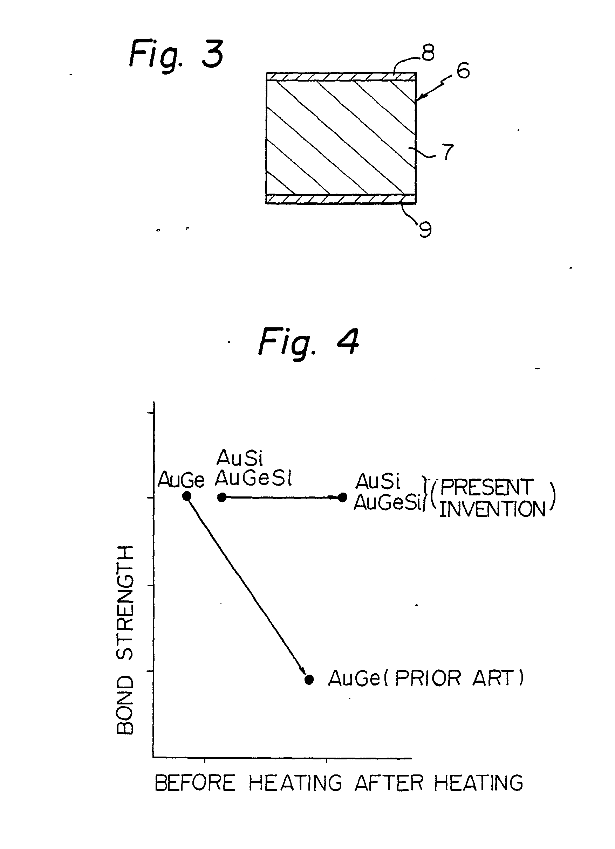

To ground the lower surface of the integrated-circuit chip 5 a metal terminal chip 6 is attached to the gold layer 2 prior to IC chip attaching step or a wire bonding step to create predetermined electrical connections between the integrated-circuit chip 5 and the leads 4. If the terminal metal chip 6 is not provided, then an aluminium micro-wire (i.e. a bonding wire) is used to connect the gold layer 2 to a lead of the frame to be grounded. In this case, the aluminium and gold commonly form an intermetallic compound of purple or white plague or plaque when a sealing step of the package is carried out at a temperature of from 400°C to 500°C. This intermetallic compound weakens the bond strength and decreases the electric conductivity, with the result that bond failure may occur. To overcome this it has been proposed to use a metal terminal chip 6 comprising e.g. a metal base 7 being e.g. of an Fe-Ni-Co alloy or an Fe-Ni alloy, an aluminium-silicon (AlSi) alloy or aluminium (Al) thin layer 8 formed on the upper surface of the base 7, and a gold-germanium (AuGe) alloy thin layer 9 formed on the lower surface of the base 7, as is illustrated in Figure 3. Such a metal terminal chip is disclosed in Japanese Unexamined Patent Publication JP-A-55-27615. The terminal metal chip 6 can be produced by putting an Al or AlSi film and an AuGe film on the upper surface and the lower surface of a metal plate, respectively, rolling the films with pressure rollers to form a laminated plate, and punching the plate to form chips. The obtained metal chip has a predetermined shape, e.g. a circular or rectangular shape. To attach the metal terminal chip 6 to the package substrate 1 while the substrate 1 is being heated at a temperature of from 400°C to 450°C, the chip 6 is put on the gold layer 2 so as to bring the AuGe layer 9 into contact with the gold layer 2. Then the gold layer 2 is scrubbed with the chip 6. As a result, the AuGe layer 9 and the gold layer 2 are melted and alloyed. After cooling, the chip 6 sticks to the gold layer 2, i.e. the substrate 1. Then aluminium wires 10 are attached between bonding pads (i.e. contact areas) 11 of the integrated-circuit chip 5 and the terminal areas of the leads 4 by using ultrasonic bonding techniques. In this wire bonding step, an aluminium wire 12 is also attached between the Al or AlSi layer 8 of the terminal metal chip 6 and a predetermined lead 4A. Therefore, the integrated-circuit chip 5 is grounded via the terminal metal chip 6.

Finally, a ceramic cap 13 (Figure 1) with a a pre-baked glass layer 14 having a low melting point is put on the glass layer 3 and on the leads 4, and the substrate 1 and the cap 13 are heated at a temperature of from 400°C to 500°C in a furnace. Since the glass layer 14 has a low melting point similar to that of the glass layer 3 the layer 14 is made of the same material as is the layer 3, the glass layer 14 and 13 are melted and are combined into a sealing glass layer. Upon cooling, an hermetically sealed package is produced.

However, we have found that when the metal chip 6 was bonded to the package substrate 1 the bond strength was remarkably reduced. Possibly this was caused by the AuGe alloy layer between the metal chip 6 and the gold layer 2 alloying in an uncontrolled manner with silicon, which diffuses from the integrated circuit chip 5 through the gold layer 2 during the heating treatment for sealing, thus forming an uncontrolled gold-germanium-silicon (AuGeSi) alloy. A reduction in the bond strength may result in body failure and thus decrease the reliability of the semiconductor device.

Three types of terminal metal chips 6 having the same dimensions are prepared in the above-mentioned manner. As is illustrated in Figure 3, the metal chips 6 each comprise a metal base 7 having a thickness similar to the thickness of an integrated circuit chip, e.g. about 0.5mm, an upper coating layer 8 having a thickness of from 5 to 15μm, e.g. about 10μm and a lower coating layer 9 having a thickness of from 25 to 35 μm, e.g. about 30μm. The plane shape of the metal chips 6 is a desired form, e.g. a circle having a diameter of 0.9 mm. The metal base 7 and the upper coating layer 8 of all of the terminal metal chips are made of a Fe-Ni-Co alloy and an AlSi alloy, respectively. The lower coating layer 9 is made of an AuSi alloy in a first terminal metal chip, is made of a AuGeSi alloy in a second terminal metal chip, and is made of a AuGe alloy in a third terminal metal chip. The first and second terminal metal chips are embodiments of the present invention, and the third terminal metal chip is a conventional chip.

Each of the three types of terminal metal chips is attached to the gold layer 2 formed on the package substrate 1 (Figures 1 and 2) by scrubbing while the substrate 1 is being heated at a temperature of 430°C and after the integrated-circuit chip 5 of silicon is attached to the gold layer 2. After cooling, all of the package substrates, along with the terminal metal chips, are heated at a temperature of 450°C. This heat treatment is carried out under the same conditions as those in the case of glass sealing.

The bond strength of the terminal metal chips is measured by applying a force to each of the terminal metal chips in a horizontal direction in an attempt to remove the chip both before and after heating. The measurement results are shown in Figure 4. As is evident from Figure 4, after the heating step, the bond strength of the first and second terminal metal chips having AuSi and AuGeSi lower coating layers, respectively, is not decreased substantially, but the bond strength of the third terminal metal chip having a AuGe layer is remarkably decreased to about one third the initial value. Accordingly, the lower coating layer 9 is made of a AuSi type of alloy in accordance with the present invention instead of a AuGe alloy, whereby a decrease in the bond strength of the terminal metal chip can be prevented. Thus, semiconductor devices so produced have an improved reliability in comparison with a conventional semiconductor device.

**Claims**

1. A semiconductor device comprising a package including a cap (13), a package substrate (1) and glass layers (3, 14) on the substrate (1) and cap (13), the package including a gold layer (2), terminal areas, a silicon integrated-circuit chip (5) attached to the gold layer (2), a conductive metal terminal chip (6) attached to the gold layer (2), and bonding wires (10, 12) for electrically connecting the terminal areas to the integrated-circuit chip (5) and to the metal terminal chip (6), the conductive metal terminal chip (6) having an upper coating layer (8) of an aluminium or an aluminium-silicon alloy to enable the bonding wires (10, 12) to be bonded onto it, characterised in that the conductive metal terminal chip (6) has a lower coating layer (9) of a gold-silicon type of alloy to enable it to be bonded onto the gold layer (2) and to maintain its bond strength with the gold layer (2) when the package is heated to join and hermetically seal the cap (13) and the package (1) using the glass layers (3, 14).

2. A semiconductor device according to claim 1, in which the metal chip (6) is made of an iron-nickel-cobalt alloy, or an iron-nickel alloy.

3. A semiconductor device according to claim 1 or claim 2, in which the gold-silicon type of alloy is an alloy of gold and silicon, or an alloy of gold, germanium and silicon.

4. A semiconductor device according to any one of the preceding claims, in which the gold-silicon type of alloy is an alloy of gold and silicon having a silicon content in a range from 1% to 8% by weight.

5. A semiconductor device according to any one of the claims 1 to 3, in which the gold-silicon type alloy is an alloy of gold, germanium and silicon having a silicon content in a range from 0.3% to 3% by weight and a germanium content in a range from 12 to 0% by weight.

## Patentansprüche

1. Halbleitervorrichtung mit einer Packung mit einer Kappe (13), einem Packungssubstrat (1) und Glasschichten (3, 14) auf dem Substrat (1) und der Kappe (13), welche Packung eine Goldschicht (2), Anschlußbereiche, ein an der Goldchicht (2) befestigtes Siliciumchip (5) mit integrierten Schaltungen, ein an der Goldschicht (2) befestigtes, leitendes Metallanschlußchip (6) und Bonding-Drähte (10, 12) zum elektrischen Verbinden der Anschlußbereiche mit dem Chip (5) mit integrierten Schaltungen und mit dem Metallanschlußchip (6) umfaßt, bei der das leitende Metallanschlußchip (6) eine obere überzugsschicht (8) aus einem Aluminium oder einer Aluminiumlegierung hat, um zu ermoglichen, daß die Bonding-Drähte (10, 12) an sie gebondet werden, dadurch gekennzeichnet, daß das leitende Metallanschlußchip (6) eine untere überzugsschicht (9) aus einer Legierung von einem Gold-Silicium-Typ hat, um zu ermöglichen, daß es auf die Goldschicht (2) gebondet wird, und um seine Bondingtärke mit der Goldschicht (2) aufrechtzuerhalten, wenn die Packung erhitzt wird, um die Kappe (13) unter Verwendung der Glasschichten (3, 14) mit der Packung (1) zu vereinigen und hermetisch zu versiegeln.

2. Halbleitervorrichtung nach Anspruch 1, bei welcher das Metallchip (6) aus einer Eisen-Nickel-Kobalt-Legierung oder aus einer Eisen-Nickel-Legierung hergestellt ist.

3. Halbleitervorrichtung nach Anspruch 1 oder 2, bei der die Legierung vom Gold-Silicium-Typ eine Legierung aus Gold und Silicium oder eine Legierung aus Gold, Germanium und Silicium ist.

4. Halbleitervorrichtung nach einem der vorhergehenden Ansprüche, bei der die Legierung vom Gold-Silicium-Typ eine Legierung aus Gold und Silicium ist, welche einen Siliciumgehalt im Bereich von 1 Gewichts-% bis 8 Gewichts-% hat.

5. Halbleitervorrichtung nach einem der Ansprüche 1 bis 3, bei der die Gold-Silicium-Typ-Legierung eine Legierung aus Gold, Germanium und Silicium ist, welche einen Siliciumgehalt im Bereich von O,3 Gewichts-% bis 3 Gewichts-% und einen Germaniumgehalt im Bereich von 12 bis 0 Gewichts-% hat.

## Revendications

1. Dispositif à semiconducteur comprenant un boîtier incluant -un capuchon (13), un substrat de boîtier (1) et des couches de verre (3,14) sur le substrat (1) et le capuchon (13), le boîtier incluant une couche d'or (2), des zones de sortie, une puce de circuit intégré au silicium (5) fixée à la couche d'or (2), une puce de sortie de métal conductrice (6) fixée à la couche d'or (2), et des fils de liaison (10,12) pour connecter électriquement les zones de sorties à la puce de circuit intégré (5) et à la puce de sortie de métal (6), la puce de sortie de métal conductrice (6) comportant une couche de revêtement supérieur (8) en aluminium ou en alliage d'aluminium-silicium pour permettre aux fils de liaison (10,12) d'être soudés sur celle-ci, caractérisé en ce que la puce de sortie de métal conductrice (6) comporte une couche de revêtement inférieur (9) d'un type d'alliage or-silicium pour lui permettre d'être soudée sur la couche d'or (2) et pour maintenir sa force de liaison avec la couche d'or (2) quand le boîtier est chauffé pour joindre et fermer hermétiquement le capuchon (13) et le boîtier (1) en utilisant les couches de verre (3,14).

2. Dispositif à semiconducteur selon la revendication 1, dans lequel la puce de métal (6) est constituée d'un alliage de fernickel-cobalt ou d'un alliage de fer-nickel.

3. Dispositif à semiconducteur selon l'une quelconque des revendications 1 et 2, dans lequel le type d'alliage or-silicium est un alliage d'or et de silicium, ou un alliage d'or, de germanium et de silicium.

4. Dispositif à semiconducteur selon l'une quelconque des revendications 1 à 3, dans lequel le type d'alliage or-silicium est un alliage d'or et de silicium ayant une teneur en silicium comprise entre l% et 8% en poids.

5. Dispositif à semiconducteur selon l'une quelconque des revendications 1 à 3, dans lequel le type d'alliage or-silicium est un alliage d'or, de germanium et de silicium ayant une teneur en silicium comprise entre 0,3% et 3% en poids et une teneur en germanium comprise entre 12 et 0% en poids.

# Fig. 1

# Fig. 2

*Fig. 3*

*Fig. 4*